# EUROPÄISCHE PATENTANMELDUNG

(11) **EP 4 818 582 A1**
(43) Veröffentlichungstag der Anmeldung: **07.10.2026**
(21) Anmeldenummer: 26168780.0
(22) Anmeldetag: 27.03.2026
(51) Int. Cl.: F21V 19/00

(54) **BEFESTIGUNGSSYSTEM FÜR EINE ELEKTRONISCHE PLATINE**

(30) Priorität: 31.03.2025 LU 600959
(71) Anmelder: BEGA Gantenbrink-Leuchten KG, 58708 Menden (DE)
(72) Erfinder: Golew, Michael, 58638 Iserlohn (DE)
(74) Vertreter: Habermann Intellectual Property Partnerschaft von Patentanwälten mbB

(57) **Zusammenfassung**

Die Erfindung betrifft ein Befestigungssystem für eine elektronische Platine (1) an einem tragenden Teil (2), wobei die Platine (1) zumindest einen elastisch verformbaren Befestigungsbereich (3) aufweist, der beim Einsetzen in eine aufnehmende Struktur eines am tragenden Teil (2) vorgesehenen Halteelements (6) durch elastische Verformung in Eingriff bringbar ist, sodass eine mechanische Halteverbindung herstellbar ist.

## Beschreibung

Die Erfindung betrifft ein Befestigungssystem für eine elektronische Platine an einem tragenden Teil sowie eine Leuchte mit einer solchen Platine.

Elektronische Platinen, beispielsweise Leiterplatten mit LED-Komponenten, werden typischerweise durch Schrauben, Klammern oder zusätzliche Halteelemente an einem Gehäuse oder Träger befestigt. Diese bekannten Befestigungsverfahren erfordern zusätzliche Bauteile, Werkzeuge und Montageschritte, was den Fertigungs- und Wartungsaufwand erhöht. Zudem besteht insbesondere bei sensiblen Bauteilen wie LEDs die Gefahr mechanischer Beschädigungen beim Ein- oder Ausbau. Der Austausch oder die Demontage der Platine gestaltet sich oftmals aufwendig, insbesondere bei begrenztem Bauraum.

Es sind auch Lösungen bekannt, bei denen Platinen über Rast- oder Schnappverbindungen in einem Gehäuse fixiert werden. Diese Systeme verwenden jedoch zumeist separate Clips, Klammern oder elastische Aufnahmen, die fest mit dem Gehäuse verbunden sind. Die Platine selbst bleibt dabei ein passives Element. Eine aktive Mitwirkung der Platine an der Befestigungsfunktion ist in der Regel nicht vorgesehen.

EP 3 339 724 B1 offenbart eine Leuchte mit Tragschiene und einem Befestigungselement, bei dem LED-Platinen durch Rastmittel in eine Tragschiene eingesetzt werden. Die Befestigung erfolgt werkzeuglos und nutzt separate Halteclips, die in die Tragschiene einschnappen. Die Platine selbst ist jedoch passiv.

EP 2 873 913 B1 beschreibt eine LED-Leuchte, bei der ein Abdeckprofil mit Schnapphaken von oben auf eine LED-Platine gedrückt wird. Die Fixierung erfolgt ebenfalls werkzeuglos, jedoch durch separate Befestigungsmittel, die die Platine klemmen.

US 10,251,279 B1 zeigt ein Befestigungssystem, bei dem eine Leiterplattenkante in einen federnden Rastschlitz mit korrespondierenden Raststrukturen eingeschoben wird. Die Befestigungsmittel befinden sich jedoch ausschließlich im Träger, während die Platine lediglich Aussparungen aufweist. Die Platine selbst ist nicht elastisch verformbar, sondern wird durch externe Federn gehalten.

Ein grundsätzlich anderes Konzept zeigt die US 6,934,162 B2, bei der schlüssellochförmige Montagelöcher der Platine mit Gehäusebolzen zusammenwirken. Die Platine wird durch Einschieben und anschließende Verriegelung fixiert.

In diesen bekannten Lösungen erfolgt die Befestigung der Platine stets durch externe mechanische Elemente, sei es durch Gehäusestrukturen oder zusätzlich montierte Komponenten. Damit sind diese Lösungen entweder materialaufwendig oder hinsichtlich Demontage und Austausch wenig wartungsfreundlich.

Vor diesem Hintergrund liegt der Erfindung die Aufgabe zugrunde, ein Befestigungssystem bereitzustellen, das ohne zusätzliche lösbare Befestigungsmittel auskommt und eine werkzeuglose Montage und Demontage erlaubt.

Gelöst wird die Aufgabe durch die Merkmale des Anspruchs 1. Vorteilhafte Ausgestaltungen sind in den abhängigen Ansprüchen beschrieben.

Es wird ein Befestigungssystem für eine elektronische Platine an einem tragenden Teil bereitgestellt, wobei die Platine zumindest einen elastisch verformbaren Befestigungsbereich aufweist. Dieser Befestigungsbereich ist so ausgestaltet, dass er beim Einsetzen der Platine in eine aufnehmende Struktur eines am tragenden Teil vorgesehenen Halteelements durch elastische Verformung in Eingriff gebracht werden kann. Auf diese Weise lässt sich eine mechanische Halteverbindung zwischen der Platine und dem tragenden Teil herstellen, ohne dass zusätzliche lösbare Befestigungselemente erforderlich sind.

Ein wesentlicher Vorteil des erfindungsgemäßen Befestigungssystems besteht darin, dass die Platine ohne Einsatz von Werkzeugen montiert und gegebenenfalls auch wieder demontiert werden kann. Die Anzahl an Einzelteilen wird reduziert, da auf separate Befestigungsmittel wie Schrauben, Klammern oder externe Clips verzichtet werden kann. Durch die direkte Mitwirkung der Platine an der Haltefunktion entfällt nicht nur zusätzlicher Bauraum für externe Befestigungselemente, sondern es werden auch Materialkosten und Montagezeiten reduziert. Gleichzeitig wird das Risiko mechanischer Beschädigungen während der Montage verringert, insbesondere bei empfindlichen Baugruppen wie LED-Leiterplatten.

In einer vorteilhaften Ausgestaltung ist die mechanische Halteverbindung als formschlüssiger Eingriff zwischen dem elastisch verformbaren Befestigungsbereich der Platine und dem Halteelement des tragenden Teils ausgebildet. Dabei ist vorgesehen, dass sich der Befestigungsbereich der Platine bei der Montage elastisch verformt, um beispielsweise in eine entsprechende Hinterschnittstruktur oder Ausnehmung des Halteelements zum Beispiel einzuschnappen oder einzurasten. Nach erfolgtem Eingriff stellt sich die ursprüngliche Form des Befestigungsbereichs vorteilhafterweise zumindest teilweise wieder her, sodass eine definierte geometrische Verriegelung zwischen beiden Bauteilen entsteht. Diese formschlüssige Ausgestaltung bietet den Vorteil, dass die Haltefunktion primär durch die Geometrie der miteinander in Eingriff stehenden Elemente gewährleistet ist. Dadurch ist eine sichere, wiederholbare und positionsstabile Befestigung realisierbar. Gleichzeitig ermöglicht die formschlüssige Verbindung eine exakte Positionierung etwa in Bezug auf lichttechnisch relevante Komponenten wie Linsen oder Abdeckungen.

In einer besonders vorteilhaften Ausgestaltung ist der elastisch verformbare Befestigungsbereich der Platine durch eine strukturelle Schwächung oder Teilentkopplung innerhalb des Platinenmaterials gebildet, beispielsweise in Form von Einfräsungen, Einschnitten oder Aussparungen. Diese Bereiche sind derart ausgestaltet, dass sie im eingebauten Zustand eine elastische Verformung zulassen, insbesondere bei der Einführung in die aufnehmende Struktur des Halteelements. Der Befestigungsbereich kann dabei unterschiedliche Geometrien aufweisen. So können die Aussparungen als rund, oval, schlitzförmig oder mehreckig ausgeführt sein. Auch gekrümmte oder segmentförmige Einschnitte, U-förmige Fräsungen oder kreisbogenartige Konturen sind denkbar. Besonders geeignet sind Geometrien, die lokal eine hohe Nachgiebigkeit erzeugen, ohne die strukturelle Integrität der Platine insgesamt zu beeinträchtigen. Die Anordnung der Einschnitte kann so gewählt sein, dass flexible Zungen, Stege oder Laschen im Randbereich der Platine entstehen, die bei der Montage elastisch ausgelenkt werden und nach dem Eingriff selbsttätig in ihre Ausgangslage zurückkehren. Die bevorzugten strukturellen Maßnahmen können einfach im Rahmen der Leiterplattenfertigung, etwa durch Fräsen oder Stanzen, umgesetzt werden.

Es ist bevorzugt, dass zumindest ein elastisch verformbarer Befestigungsbereich im Randbereich der Platine angeordnet ist. Der Randbereich ist dabei insbesondere der äußere Bereich der Leiterplatte, der außerhalb der elektrisch oder thermisch funktionalen Flächen liegt und damit konstruktiv für mechanische Zwecke genutzt werden kann, ohne aktive Bauteile zu beeinträchtigen. Die Anordnung im Randbereich hat mehrere technische Vorteile: Zum einen ist dort ausreichend Fläche verfügbar, um Befestigungsbereiche wie beispielsweise Einschnitte, Laschen oder flexible Stege unterzubringen. Zum anderen lässt sich eine Platine mit solchen Randstrukturen besonders einfach in ein Halteelement einführen, da keine komplexe Geometrie innerhalb der Nutzfläche der Leiterplatte berücksichtigt werden muss. Durch die Positionierung im Randbereich können die elastisch verformbaren Befestigungsbereiche gezielt so gestaltet werden, dass sie beim Einsetzen der Platine zunächst elastisch ausgelenkt und anschließend durch Rückstellung in die aufnehmende Struktur eines Halteelements verrastet werden.

In einer alternativen Ausgestaltung ist zumindest ein elastisch verformbarer Befestigungsbereich nahe einer geometrischen Mitte der Platine angeordnet. Die geometrische Mitte bezieht sich dabei auf den Flächenmittelpunkt der Leiterplatte oder einen zentralen Bereich, der von den Außenkanten in etwa gleich weit entfernt ist. Die Anordnung eines solchen Befestigungsbereichs in zentraler Lage kann insbesondere dann vorteilhaft sein, wenn eine zusätzliche Stabilisierung der Platine in ihrer Mitte gewünscht ist oder wenn aufgrund der Einbausituation kein seitlicher Zugriff möglich ist. Durch die zentrale Befestigung kann ein Verkippen oder Verwinden der Platine während oder nach der Montage verhindert werden, was insbesondere bei großflächigen oder mechanisch empfindlichen Platinen von Vorteil ist. Die Befestigung im zentralen Bereich kann dabei wie zuvor beschrieben durch eine gezielte Schwächung des Materials - beispielsweise durch eine mittige Aussparung, einen schlüssellochförmigen Ausschnitt oder eine flexible Zunge - realisiert werden, die in eine korrespondierende Struktur eines Halteelements eingreift.

Es ist vorteilhaft, wenn das Befestigungssystem mehrere elastisch verformbare Befestigungsbereiche und entsprechend korrespondierende Halteelemente aufweist. Die Befestigungsbereiche können je nach Ausgestaltung der Platine über die Platine verteilt angeordnet sein. In einer weiteren bevorzugten Ausgestaltung weist das Befestigungssystem zwei oder vier elastisch verformbare Befestigungsbereiche auf, die jeweils gegenüberliegend an entgegengesetzten Seiten der Platine angeordnet sind. Diese Befestigungsbereiche sind so gestaltet und positioniert, dass sie beim Einsetzen der Platine mit jeweils einem zugeordneten Halteelement des tragenden Teils in Eingriff gebracht werden können. Die Halteelemente sind entsprechend paarweise gegenüberliegend am tragenden Teil vorgesehen und bilden mit den zugeordneten Befestigungsbereichen der Platine ein symmetrisches Einrastsystem. Diese Anordnung ermöglicht eine stabile, allseitige Fixierung der in allen Raumrichtungen. Durch die gegenüberliegende Positionierung der Befestigungsbereiche entstehen gleichmäßige Kräfteverhältnisse beim Einsetzen der Platine, was eine spannungsarme Montage begünstigt und mechanische Belastungen auf Leiterbahnen oder auf der Platine montierte Bauelemente minimiert. Die Anzahl und Position der gegenüberliegenden Befestigungsbereiche kann abhängig von der Größe, Steifigkeit und Anwendung der Platine gewählt werden. Eine Anordnung mit zwei gegenüberliegenden Befestigungspunkten eignet sich insbesondere für kompakte, rechteckige Leiterplatten, während bei größeren oder mechanisch beanspruchten Modulen eine Vierpunktbefestigung zusätzliche Stabilität gewährleistet.

In einer zweckmäßigen Weiterbildung der Erfindung besteht die Platine aus einem biegeelastischen Material, das die für die erfindungsgemäße Befestigungsfunktion erforderliche elastische Verformbarkeit der Befestigungsbereiche ermöglicht. Als geeignete Materialien kommen insbesondere glasfaserverstärkte Kunststoffe wie FR4 zum Einsatz, die in der Elektronik weit verbreitet sind und eine gute Kombination aus mechanischer Festigkeit und elastischer Nachgiebigkeit im Randbereich aufweisen. Alternativ kann die Platine auch aus einem flexiblen Verbundmaterial bestehen, das speziell für mechanisch dynamische Anwendungen entwickelt wurde und eine erhöhte Rückstellfähigkeit bei wiederholter Verformung bietet. Für Anwendungen mit erhöhtem Wärmeaufkommen, beispielsweise im Bereich von LED-Leuchten, eignet sich zudem ein sogenanntes Metallkernsubstrat (z.B. Aluminium-basiert), bei dem die Leiterplatte auf einem wärmeleitenden Träger aufgebaut ist. Auch diese Materialien können - bei geeigneter Gestaltung der Befestigungsbereiche - eine ausreichende Elastizität für das Einrasten oder Einklipsen in eine Haltestruktur aufweisen.

In einer vorteilhaften Ausgestaltung weist das tragende Teil mindestens ein Halteelement auf, das als Hinterschnitt, Rastnase oder Schnappvorsprung ausgebildet ist. Das Halteelement ist Bestandteil der aufnehmenden Struktur des tragenden Teils und dient dazu, mit dem elastisch verformbaren Befestigungsbereich der Platine in Eingriff zu treten. Dabei ist das Halteelement so gestaltet, dass es nach dem Einführen der Platine einen mechanischen Widerstand ausbildet, der nur durch elastische Verformung des Befestigungsbereichs überwunden werden kann. Ein als Hinterschnitt ausgebildetes Halteelement besitzt insbesondere eine untergreifende Geometrie, die ein rückwärtiges Herausziehen der Platine ohne Verformung verhindert. Eine Rastnase kann in eine korrespondierende Öffnung oder Ausnehmung der Platine einschnappen und so eine lagegesicherte Position einnehmen. Alternativ kann ein Schnappvorsprung so ausgebildet sein, dass er beim Einführen der Platine durch die elastische Auslenkung des Befestigungsbereichs überfahren wird und nach der Montage einen rückstellenden Formschluss erzeugt. Durch vorteilhaft ausgestaltete Halteelemente wird eine definierte, wiederholbare und mechanisch stabile Verbindung zwischen Platine und tragendem Teil erreicht, ohne dass lösbare Verbindungsmittel wie Schrauben oder Klemmvorrichtungen erforderlich sind. Die Geometrie der Halteelemente kann dabei an die Form und Elastizität der Befestigungsbereiche angepasst werden und ermöglicht eine anwendungsspezifische Auslegung hinsichtlich Haltekraft, Montageweg und Rückstellverhalten.

In einer bevorzugten Anwendung umfasst die Platine ein LED-Modul, das beispielsweise als Träger für lichtemittierende Dioden (LEDs) dient. Dabei kann es sich um eine klassische Leiterplatte mit oberflächenmontierten Bauelementen (SMD) handeln oder um ein sogenanntes Chip-on-Board-Modul (COB), bei dem die LED-Chips direkt auf das Leiterplattensubstrat aufgebracht und dort kontaktiert werden. Gerade bei LED-Modulen ist eine zuverlässige, spannungsfreie und zugleich kompakte Befestigung von besonderer Bedeutung, da diese Baugruppen häufig thermisch belastet sind und gleichzeitig eine exakte Positionierung innerhalb eines optischen Systems - beispielsweise in Bezug auf Reflektoren, Linsen oder Lichtleiter - erfordern. Das erfindungsgemäße Befestigungssystem ermöglicht eine präzise und wiederholbare Lagerung solcher LED-Module ohne zusätzlichen Bauraum für Schrauben oder Halteklammern und reduziert damit die konstruktive Komplexität von Leuchten oder LED-Trägern erheblich. Darüber hinaus profitieren LED-Module von der werkzeuglosen Montierbarkeit, da sie häufig in Serienfertigung oder im Austauschservice verarbeitet werden müssen. Die in die Platine integrierte oder mit ihr verbundene Haltestruktur erlaubt einen schnellen, beschädigungsfreien Einbau und erfüllt zugleich die hohen Anforderungen an thermische Kopplung, Vibrationssicherheit und elektrische Isolation, wie sie im LED-Bereich üblich sind.

Es ist bevorzugt, dass die Halteverbindung derart ausgestaltet ist, dass sie zusätzlich zu ihrer mechanischen Funktion eine definierte thermische Anbindung und/oder elektrische Isolation zwischen der Platine und dem tragenden Teil ermöglicht. Dies bedeutet, dass die Befestigung nicht nur der Fixierung der Platine dient, sondern auch zur Wärmeableitung bzw. zur elektrischen Entkopplung beiträgt. Die thermische Anbindung ist insbesondere bei LED-Modulen vorteilhaft, da die entstehende Verlustwärme effizient an das Gehäuse oder einen Kühlkörper abgeführt werden muss, um die Lebensdauer und Lichtausbeute der Leuchtdioden zu sichern. Durch das erfindungsgemäße Befestigungssystem kann eine flächige Anlage der Platine an dem tragenden Teil und somit ein enger thermischer Kontakt herstellbar sein. Hierbei kann das tragende Teil als Wärmeleiter fungieren und die Wärme direkt oder über eine Zwischenschicht (z.B. Wärmeleitpad) ableiten. Gleichzeitig kann die Halteverbindung so gestaltet sein, dass zwischen elektrischen Leiterstrukturen auf der Platine und dem tragenden Teil ein definierter Abstand eingehalten wird. Durch den Einsatz isolierender Materialien im Bereich der Halteelemente oder durch geometrisch begrenzte Kontaktflächen kann so eine elektrische Entkopplung realisiert werden, die das Überschreiten von Kriech- und Luftstrecken gemäß einschlägiger Sicherheitsnormen verhindert.

Der tragende Teil kann in Abhängigkeit von der konkreten Anwendung unterschiedliche Ausgestaltungen aufweisen. In einer bevorzugten Ausführungsform handelt es sich bei dem tragenden Teil um ein Gehäuse oder ein Gehäuseteil einer Leuchte. Alternativ kann der tragende Teil ein Reflektorelement oder ein Optikträger sein, insbesondere dann, wenn die Platine mit lichtemittierenden Dioden bestückt ist und in unmittelbarer Nähe zu einem optischen System positioniert werden soll. In weiteren Ausführungsformen kann der tragende Teil ein stranggepresstes Trägerprofil sein, wie es beispielsweise bei linearen Leuchten oder modularen Lichtleisten eingesetzt wird. Ebenso denkbar ist eine Montageplatte oder Trägerplatte, beispielsweise aus thermisch leitfähigem Kunststoff oder Metall, die sowohl als mechanisches Aufnahmemittel für die Platine als auch zur thermischen Anbindung dient. Auch ein Kühlkörper, der Bestandteil des Leuchtenaufbaus sein kann, kann als tragender Teil fungieren, sofern er die zur Aufnahme der Halteelemente notwendigen Strukturen aufweist.

Darüber hinaus kann der tragende Teil ein Gehäuseboden oder Halterahmen innerhalb eines Elektronikmoduls sein, etwa in Steuergeräten, Sensorbaugruppen oder Verbindungseinheiten. In bestimmten Ausgestaltungen kann auch ein Bauteil zur Zugentlastung oder ein mechanisches Abdeckelement mit Rastgeometrie als tragender Teil wirken, sofern es zur form- bzw. kraftschlüssigen Fixierung der Platine beiträgt. Die Konstruktion des tragenden Teils ist somit variabel und kann je nach Systemanforderung mechanische, thermische oder auch elektrische Zusatzfunktionen übernehmen.

Es kann vorteilhaft sein, wenn dass das tragende Teil Positionierungselemente aufweist, die einen Anschlag für die gehaltene Platine bilden. Die Positionierungselemente können in Gestalt von Kanten, Erhebungen, Führungsstifte, Stege, Schulterflächen, Anlageflächen, Anschlagsnasen oder dergleichen vorliegen und ein Verrutschen einer gehaltenen Platine auf dem tragenden Teil verhindern. Hierdurch kann die Lagesicherung oder Fixierung der Platine verbessert werden.

Die Erfindung betrifft ferner eine Leuchte, umfassend ein Befestigungssystem, ein Gehäuse, eine elektronische Platine mit mindestens einer lichtemittierenden Diode (LED) sowie mindestens ein am Gehäuse vorgesehenes Halteelement zur Aufnahme und Fixierung der Platine. Die Platine weist hierzu zumindest einen elastisch verformbaren Befestigungsbereich auf, der beim Einsetzen in eine aufnehmende Struktur des Halteelements durch elastische Verformung in Eingriff gebracht werden kann. Dadurch lässt sich eine mechanische Halteverbindung zwischen der Platine und dem Gehäuse herstellen, ohne dass zusätzliche lösbare Befestigungselemente erforderlich sind. Insbesondere betrifft die Erfindung eine Leuchte mit einem zuvor erläuterten Befestigungssystem.

Die Leuchte kann insbesondere eine oder mehrere lichttechnische und mechanische Komponenten umfassen, wie etwa eine Linse, eine transparente Abdeckung, ein Reflektorelement, einen Kühlkörper, eine Dichtung oder eine Anschluss- bzw. Zugentlastungseinheit. Die elektronische Platine dient in diesem Zusammenhang typischerweise als Träger für LED-Komponenten sowie gegebenenfalls für steuerungstechnische, versorgungstechnische oder sensortechnische Funktionseinheiten. Durch die erfindungsgemäße Ausbildung der Befestigung entfällt die Notwendigkeit von Schrauben, Klammern oder separaten Halteclips, was die Montage vereinfacht, die Baugröße der Leuchte reduziert und das Risiko mechanischer Beschädigungen minimiert. Gleichzeitig lässt sich die Platine exakt und lagegesichert im Gehäuse positionieren, was insbesondere bei optisch wirksamen Elementen wie Linsen oder Reflektoren von Vorteil ist. Die elastische Rückstellfähigkeit der Befestigungsbereiche ermöglicht zudem eine zerstörungsfreie Demontage, beispielsweise im Rahmen von Wartungsarbeiten oder zum Austausch einzelner Komponenten. Dadurch eignet sich das System auch besonders für modular aufgebaute oder servicefreundlich gestaltete Leuchten.

In einer bevorzugten Ausgestaltung umfasst das Gehäuse der Leuchte zusätzlich mindestens eine Linse, eine Abdeckung oder eine optische Streu- oder Führungseinheit. Diese Elemente sind Bestandteil des lichttechnischen Systems der Leuchte und dienen der gezielten Formung, Streuung oder Abschirmung des von der LED emittierten Lichts. Sie können einzeln oder in Kombination eingesetzt werden, um die gewünschte Lichtverteilung, Blendungsbegrenzung oder Schutzfunktion zu erzielen. Die Linse kann beispielsweise als Präzisionsoptik aus transparentem Kunststoff oder Glas ausgeführt sein und zur direkten Lichtbündelung oder Entfaltung von Abstrahlcharakteristiken wie Spot- oder Flutlicht verwendet werden. Eine transparente Abdeckung dient daneben dem mechanischen Schutz der LED-Platine sowie der Umgebung vor Verschmutzung oder Feuchtigkeit. Optische Streuelemente können das Licht gleichmäßig über eine Fläche verteilen, während Lichtführungselemente - etwa in Form von Prismen oder Lichtleitern - eine gezielte Umlenkung des Lichts ermöglichen können. Die erfindungsgemäße Halteverbindung der Platine erlaubt eine lagegenaue Positionierung der LED im Gehäuse, sodass die optischen Elemente exakt zur Strahlungsquelle ausgerichtet werden können. Dies verbessert die Effizienz und die Lichtqualität der Leuchte und erleichtert gleichzeitig die Montage und Austauschbarkeit der Komponenten. Da keine zusätzlichen Befestigungsmittel notwendig sind, können die lichttechnischen Elemente ebenfalls platzsparend und montagefreundlich in das Gehäuse integriert werden.

In einer vorteilhaften Ausgestaltung ist die aufnehmende Struktur des Halteelements so ausgebildet, dass sie den elastisch verformbaren Befestigungsbereich der Platine zumindest bereichsweise aufnehmen kann. Die aufnehmende Struktur kann dabei unterschiedliche Geometrien aufweisen, insbesondere als Ausnehmung, Tasche, Hinterschnitt, Rastöffnung oder als elastisch nachgiebige Führung ausgeführt sein. Je nach konstruktivem Aufbau des Halteelements kann die aufnehmende Struktur beispielsweise eine definierte Aufnahmetasche mit einer Rückhaltekante bilden, in welche der verformbare Bereich der Platine beim Einsetzen elastisch hineinbewegt wird. Alternativ kann ein Hinterschnitt so ausgebildet sein, dass der Befestigungsbereich beim Einschieben über eine Einführkontur hinweggeführt wird und anschließend formschlüssig hinter einer Rastkante einrastet. Auch elastisch nachgiebige Führungen, etwa in Form flexibler Zungen oder Lamellen im Gehäuse, können als aufnehmende Strukturen wirken, indem sie den Befestigungsbereich aufnehmen und durch Rückstellkraft fixieren.

Weitere vorteilhafte Ausgestaltungen werden anhand von in der Zeichnung dargestellten Ausführungsbeispielen näher erläutert.

Es zeigen:
- Figur 1: eine perspektivische Ansicht einer Platine und eines tragenden Teils,
- Figur 2: eine perspektivische Ansicht einer Platine, die an einem tragenden Teil befestigt ist,
- Figur 3: eine Schnittansicht der Figur 2,
- Figur 4: eine Vergrößerung des Ausschnitts aus Figur 3,
- Figur 5: eine Draufsicht einer Alternative, einer auf einem tragenden Teil befestigten Platine,
- Figur 6: eine Schnittdarstellung der Figur 5 und
- Figur 7: eine perspektivische Ansicht eines tragenden Teils mit Halteelementen und Positionierungselementen.

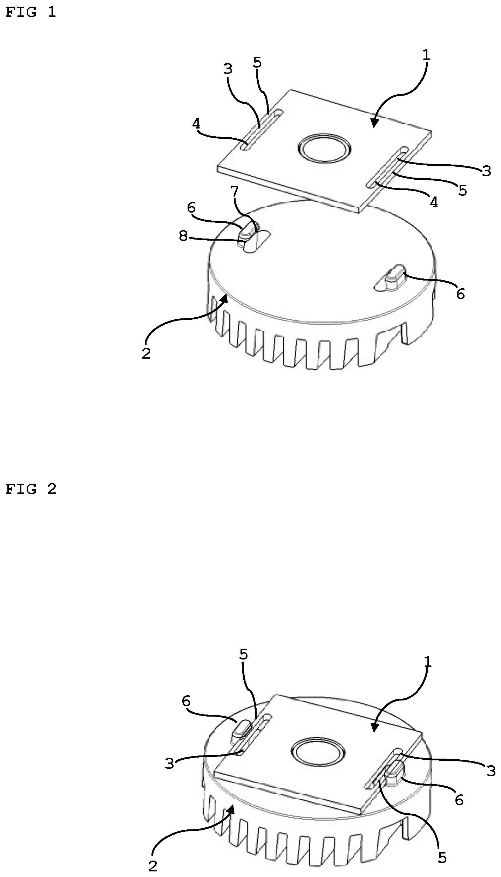

Fig. 1 zeigt eine perspektivische Ansicht einer Platine und eines tragenden Teils. Die Platine 1 ist plattenförmig ausgebildet und wird in Montagerichtung auf das tragende Teil 2 zubewegt. Im gezeigten Beispiel sind entlang zweier gegenüberliegender Seiten der Platine 1 zwei elastisch verformbare Befestigungsbereiche 3 vorgesehen. Jeder Befestigungsbereich 3 ist durch eine schlitzförmige Ausnehmung 4 gebildet, sodass ein flexibler Steg 5 entsteht, der mit dem verbleibenden Platinenteil elastisch verbunden ist. Mittig in der Platine 1 kann eine Aufnahme für z. B. ein LED-Modul vorgesehen sein.

Das tragende Teil 2 weist zwei Halteelemente 6 in Form von Rastnasen auf, die jeweils eine Einführschräge 7 und einen rückwärtigen Hinterschnitt 8 besitzen. Die Halteelemente 6 ragen im Wesentlichen senkrecht von einer Oberfläche des tragenden Teils 2. Die Gestaltung der Halteelemente 6 orientiert sich insbesondere an den geometrischen Eigenschaften der Platine 1, das heißt, insbesondere die Höhe der Halteelemente 6 als auch die Gestaltung des Hinterschnitts 8 ist an die Gestaltung der Platine 1 angepasst. Die Anordnung ist so gewählt, dass beim Einsetzen der Platine 1 der Steg 5 elastisch ausgelenkt und nach Überwindung der Einführschrägen 7 hinter den Hinterschnitten 8 einrasten.

Fig. 2 zeigt eine perspektivische Ansicht einer Platine, die an einem tragenden Teil befestigt ist. Die elastisch verformbaren Befestigungsbereiche 3 befinden sich nun in Eingriffsstellung mit den Halteelementen 6. Die Stege 5 haben sich nach der elastischen Verformung zumindest teilweise zurückgestellt und verrasten in Formschluss mit den Hinterschnitten 8 der Rastnasen. Die Platine 1 ist dadurch lagegesichert und mechanisch fixiert, ohne dass zusätzliche Befestigungselemente erforderlich sind.

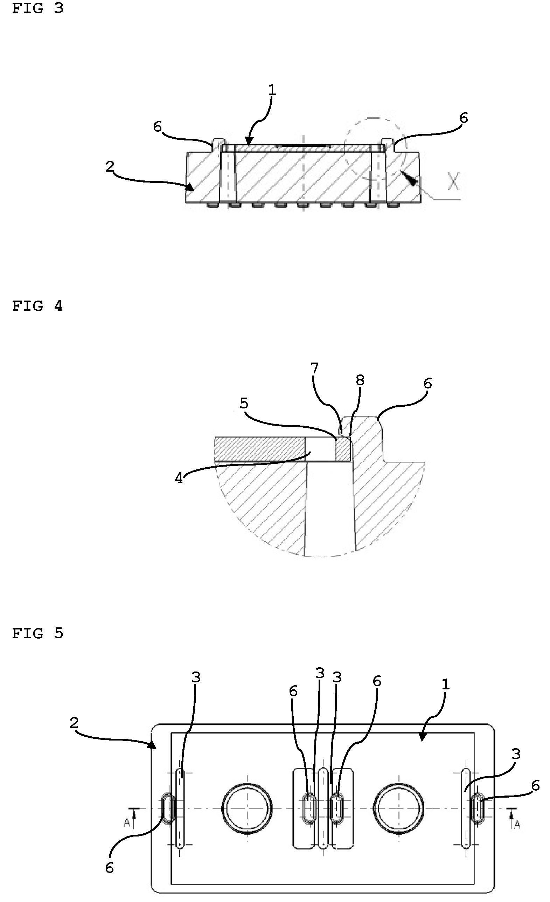

In Fig. 3 zeigt eine Schnittansicht der Figur 2 entlang einer vertikalen Ebene durch einen der Befestigungspunkte im montierten Zustand und Fig. 4 eine vergrößerte Darstellung des in Fig. 3 markierten Rastbereichs. Dargestellt ist die Platine 1 mit dem Befestigungsbereich 3, der durch die schlitzförmige Ausnehmung 4 einen flexiblen Steg 5 bildet. Dieser liegt im eingerasteten Zustand hinter dem Hinterschnitt 8 des als Rastnase gestalteten Halteelements 6 des tragenden Teils 2 an. Der Formschluss entsteht dadurch, dass der freie Endbereich des Stegs 5 unter Vorspannung gegen die Rastnase gedrückt wird. Die Rastnase ist Bestandteil des Halteelements 6, das eine aufnehmende Struktur 9 umfasst. Diese Struktur ist beispielsweise als Tasche mit Hinterschnitt 8 ausgebildet, in welche der elastisch verformbare Steg 5 der Platine 1 bei der Montage einschnappt. Das Halteelement 6 kann eine Einführschräge 7 aufweisen.

Die Geometrie der Ausnehmung 4, der Rastnase 6 sowie des Hinterschnitts 8 ist so gewählt, dass ein definierter Formschluss besteht, der eine zuverlässige und wiederlösbare Halteverbindung gewährleistet.

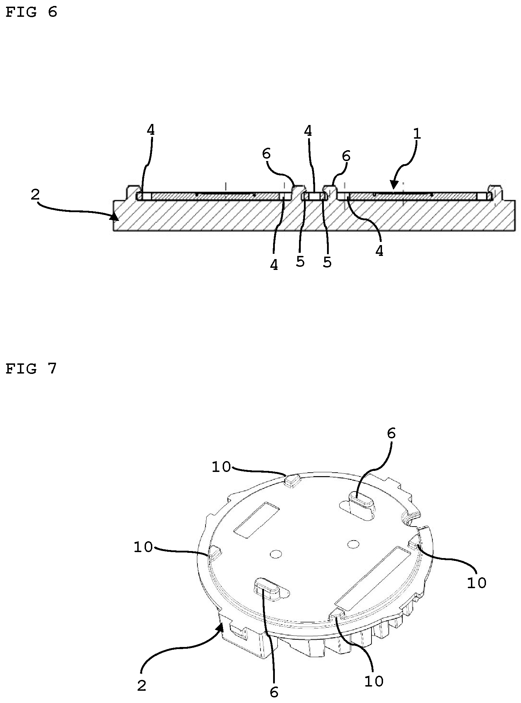

Fig. 5 zeigt eine Draufsicht einer Alternative, einer auf einem tragenden Teil befestigten Platine 1, bei der zusätzlich zu den Befestigungsbereichen 3 im Randbereich auch ein mittig angeordneter Befestigungsbereich 3 vorgesehen ist und Fig. 6 eine Schnittdarstellung der Fig. 5. Der mittige Befestigungsbereich 3 ist ebenfalls durch schlitzförmige Ausnehmungen 4 gebildet, sodass in der Ausgestaltung zwei zentrale, elastisch verformbare Stege 5 entstehen. Diese ermöglichen eine zusätzliche Fixierung der Platine 1 im Bereich ihrer geometrischen Mitte und verbessert die Abstützung gegen Verformung oder Vibration.

Fig. 6 zeigt einen vertikalen Schnitt durch die mittige Haltezone der Ausführungsform gemäß Fig. 5. Die mittig angeordneten Stege 5 der zentralen Befestigungsbereiche 3 sind in Eingriff mit zugeordneten Halteelementen 6, die sich am tragenden Teil 2 befinden. Auch diese Halteelemente 6 sind als Rastnase mit Einführschräge und Hinterschnitt ausgebildet. Das Funktionsprinzip der Rastverbindung entspricht dem der Randbereiche und erlaubt eine zusätzliche Haltestelle zur zentralen Abstützung der Platine 1.

In Figur 7 ist eine perspektivische Ansicht eines tragenden Teils mit Halteelementen und Positionierungselementen dargestellt. Das tragende Teil 2 weist eine Fläche auf, die zur Anlage der Platine vorgesehen und ausgebildet ist. Die Platine kann hierauf mit den Halteelementen 6 gehalten werden. Je nach Anwendung kann die Anzahl der Halteelemente 6 variieren. Um ein Verrutschen der Platine zu verhindern, bzw. zu reduzieren, was gerade bei einer geringen Anzahl von Halteelementen 6 vorteilhaft sein kann, können Positionierungselemente 10 auf dem tragenden Teil 2 vorgesehen sein. Die Positionierungselemente 10 sind in der gezeigten Ausgestaltung als Anschlagkanten ausgebildet und befinden sich im Randbereich des tragenden Teils 2, so dass eine seitliche Bewegung einer eingelegten Platine durch die Positionierungselemente 10 verhindert wird.

### Bezugszeichenliste

- 1.: Platine
- 2.: Tragendes Teil
- 3.: Elastisch verformbarer Befestigungsbereich
- 4.: Ausnehmung
- 5.: Steg
- 6.: Halteelement
- 7.: Einführschräge
- 8.: Hinterschnitt
- 9.: Aufnehmende Struktur des Halteelements
- 10.: Positionierungselemente

## Patentansprüche

1. Befestigungssystem für eine elektronische Platine (1) an einem tragenden Teil (2), wobei die Platine (1) zumindest einen elastisch verformbaren Befestigungsbereich (3) aufweist, der beim Einsetzen in eine aufnehmende Struktur eines am tragenden Teil (2) vorgesehenen Halteelements (6) durch elastische Verformung in Eingriff bringbar ist, sodass eine mechanische Halteverbindung herstellbar ist.

2. Befestigungssystem nach Anspruch 1, **dadurch gekennzeichnet, dass** die die mechanische Halteverbindung als formschlüssiger Eingriff zwischen dem elastisch verformbaren Befestigungsbereich (3) und dem Halteelement (6) des tragenden Teils (2) ausgebildet ist.

3. Befestigungssystem nach einem der vorherigen Ansprüche, **dadurch gekennzeichnet, dass** der elastisch verformbare Befestigungsbereich (3) durch Einfräsungen, Einschnitte oder Aussparungen an der Platine (1) gebildet ist.

4. Befestigungssystem nach einem der vorherigen Ansprüche, **dadurch gekennzeichnet, dass** zumindest ein elastisch verformbarer Befestigungsbereich (3) im Randbereich der Platine (1) angeordnet ist.

5. Befestigungssystem nach einem der vorherigen Ansprüche, **dadurch gekennzeichnet, dass** zumindest ein elastisch verformbarer Befestigungsbereich (3) nahe einer geometrischen Mitte der Platine (1) angeordnet ist.

6. Befestigungssystem nach einem der vorherigen Ansprüche, **dadurch gekennzeichnet, dass** zwei oder vier gegenüberliegend an entgegengesetzten Seiten der Platine (1) angeordnete Befestigungsbereiche (3) vorgesehen sind, die mit korrespondierenden am tragenden Teil (2) vorgesehenen Halteelementen (6) in Eingriff bringbar sind.

7. Befestigungssystem nach einem der vorherigen Ansprüche, **dadurch gekennzeichnet, dass** die Platine (1) aus einem biegeelastischen Material besteht, insbesondere aus glasfaserverstärktem Kunststoff (FR4), einem flexiblen Verbundmaterial oder einem Metallkernsubstrat.

8. Befestigungssystem nach Anspruch 1, **dadurch gekennzeichnet, dass** das tragende Teil (2) mindestens ein Halteelement (6) aufweist, das als Hinterschnitt, Rastnase oder Schnappvorsprung ausgebildet ist.

9. Befestigungssystem nach einem der vorhergehenden Ansprüche, **dadurch gekennzeichnet, dass** die aufnehmende Struktur (9) des Halteelements (6) als Ausnehmung, Tasche, Hinterschnitt, Rastöffnung oder als elastisch nachgiebige Führung ausgebildet ist, in die der elastisch verformbare Befestigungsbereich (3) der Platine (1) zumindest bereichsweise einführbar ist.

10. Befestigungssystem nach einem der vorherigen Ansprüche, **dadurch gekennzeichnet, dass** die Platine (1) ein LED-Modul umfasst, insbesondere mit oberflächenmontierten Bauelementen (SMD) oder in Chip-on-Board-Technologie (COB).

11. Befestigungssystem nach einem der vorherigen Ansprüche, **dadurch gekennzeichnet, dass** die Halteverbindung derart ausgestaltet ist, dass sie zusätzlich eine definierte thermische Anbindung und/oder elektrische Isolation zwischen Platine (1) und tragendem Teil (2) ermöglicht.

12. Befestigungssystem nach einem der vorherigen Ansprüche, **dadurch gekennzeichnet, dass** das tragende Teil (2) Positionierungselemente (10) aufweist, die einen Anschlag für die gehaltene Platine (1) bilden.

13. Leuchte, umfassend ein Befestigungssystem nach einem oder mehreren der vorherigen Ansprüche, ein Gehäuse, eine elektronische Platine mit mindestens einer LED sowie mindestens ein am Gehäuse vorgesehenes Halteelement (6), wobei die Platine (1) zumindest einen elastisch verformbaren Befestigungsbereich (6) aufweist, der beim Einsetzen in eine aufnehmende Struktur (9) des Halteelements (6) durch elastische Verformung in Eingriff bringbar und eine mechanische Halteverbindung zwischen der Platine (1) und dem Gehäuse herstellbar ist.

14. Leuchte nach Anspruch 12, **dadurch gekennzeichnet, dass** das Gehäuse zusätzlich mindestens eine Linse, eine Abdeckung oder eine optische Streu- oder Führungseinheit umfasst.
